# EUROPÄISCHE PATENTSCHRIFT

(11) **EP 2 970 698 B1**
(45) Veröffentlichungstag und Bekanntmachung des Hinweises auf die Patenterteilung: **13.12.2017**
(21) Anmeldenummer: 14722522.1
(22) Anmeldetag: 13.03.2014
(51) Int. Cl.: C09D 5/33, F24J 2/48, C09D 5/00, C09D 7/00

(54) **BESCHICHTUNG, VERFAHREN ZU DEREN HERSTELLUNG UND IHRE VERWENDUNG**
COATING, PROCESS FOR THE PRODUCTION THEREOF AND THE USE THEREOF
REVÊTEMENT, SON PROCÉDÉ DE PRODUCTION ET SON UTILISATION

(30) Priorität: 14.03.2013 DE 102013004611
(43) Veröffentlichungstag der Anmeldung: 20.01.2016
(73) Patentinhaber: Fraunhofer Gesellschaft zur Förderung der angewandten Forschung e.V., 80686 München (DE)
(72) Erfinder: ABENDROTH, Thomas, 01069 Dresden (DE); ALTHUES, Holger, 01309 Dresden (DE); MAEDER, Gerrit, 01217 Dresden (DE); KASKEL, Stefan, 01159 Dresden (DE)
(74) Vertreter: Pfenning, Meinig & Partner mbB
(86) Internationale Anmeldenummer: PCT/DE2014/000141
(87) Internationale Veröffentlichungsnummer: WO 2014/139511

(56) Entgegenhaltungen:
- WO-A2-2013/192180
- KR-A- 20110 047 515
- US-A1- 2012 090 658
- DATABASE CA [Online] CHEMICAL ABSTRACTS SERVICE, COLUMBUS, OHIO, US; 29. Januar 2008 (2008-01-29), WU, YU-CHENG ET AL: "Preparation and properties of carbon nanotube -TiO2 nanocomposites", XP002727405, gefunden im STN Database accession no. 2008:112344

## Beschreibung

Die Erfindung betrifft eine Beschichtung, die besondere Absorptionseigenschaften für elektromagnetische Strahlung aus dem Wellenlängenspektrum des Sonnenlichts aufweist, sowie ein Verfahren zur Herstellung der Beschichtung und ihre Verwendung.

Sie kann insbesondere angewendet werden, wenn Sonnenstrahlung zur Energie- bzw. Wärmegewinnung genutzt werden soll. Das Wellenlängenspektrum kann dabei wellenlängenselektiv und gezielt genutzt werden. Dabei spielt insbesondere die Absorption der elektromagnetischen Strahlung des Spektrums der von der Sonne auf eine Oberfläche emittierten Strahlung eine besondere Rolle.

So ist es bei der Herstellung von Absorberrohren, die in Parabol-Rinnen-Kollektoren eingesetzt werden, üblich, Absorberbeschichtungen vorzusehen. Dabei wird die eigentliche absorbierende Schicht aus einem Cermet gebildet.

Außerdem sind weitere Barriere- und reflektierende Schichten bei solchen Absorberbeschichtungen erforderlich und üblich. Alle diese Schichten werden dabei mittels bekannter Vakuumbeschichtungsverfahren ausgebildet, was einen entsprechend hohen Herstellungsaufwand und Kosten verursacht. Außerdem ist eine aufwändige Oberflächenbearbeitung eines so zu beschichtenden Substrats erforderlich. Je höher die Anzahl der einzusetzenden Schichten ist, je höher ist auch der Anteil an Strahlungsverlusten, so dass der Anteil an nutzbarer Strahlungsenergie dadurch reduziert ist.

Die Absorptions- und Emissionseigenschaften dieser Absorberbeschichtungen werden durch die eingesetzten Werkstoffe und Schichtdicken bestimmt.

So ist aus KR 2011 0047515 A eine Beschichtung, die Kohlenstoffnanoröhrchen enthält bekannt.

US 2012/0090658 A1 betrifft ebenfalls Beschichtungen mit Kohlenstoffnanoröhrchen.

Von Wu, Yu-Cheng ET AL, ist in "Preparation and properties of carbon nanotube- TiO2 Nanokomposites", Database CA [Online] Chemical Abstracts Service, Columbus, Ohio, US, 29. Januar 2008, die Verarbeitung von Kohlenstoffnanoröhrchen mit TiO₂ angesprochen.

Es ist daher Aufgabe der Erfindung, Möglichkeiten anzugeben, mit denen eine einfache und kostengünstige Beschichtung ausgebildet werden kann, deren Absorptions- und/oder Emissionseigenschaften vorgegeben werden können, was insbesondere bestimmte ausgewählte Wellenlängen oder Wellenlängenbereiche elektromagnetischer Strahlung betrifft.

Erfindungsgemäß wird diese Aufgabe mit einer Beschichtung, die die Merkmale des Anspruchs 1 aufweist, gelöst. Sie kann mit einem Verfahren nach Anspruch 10 hergestellt werden. Anspruch 13 gibt Verwendungen an.

Vorteilhafte Ausgestaltungen und Weiterbildungen der Erfindung können mit in untergeordneten Ansprüchen bezeichneten Merkmalen realisiert werden.

Die erfindungsgemäße Beschichtung ist mit einer Schicht, die auf der Oberfläche eines Substrats ausgebildet ist, gebildet. Sie kann auch auf einer auf der Oberfläche des Substrats ausgebildeten reflektierenden Schicht ausgebildet sein.

In der Schicht sind Kohlenstoffnanoröhren enthalten. Dabei ist der Anteil an pro Flächen- oder Volumeneinheit enthaltenen Kohlenstoffnanoröhren und/oder die Schichtdicke der Schicht so gewählt, dass elektromagnetische Strahlung aus dem Wellenlängenspektrum des Sonnenlichts mit vorgebbaren Anteilen absorbiert wird. Der Anteil an elektromagnetischer Strahlung aus dem Wellenlängenspektrum eines schwarzen Strahlers bei einer Temperatur größer als 50 °C, bevorzugt größer 200 °C und besonders bevorzugt größer 350 °C soll deutlich weniger emittiert werden. Dieser Anteil sollte kleiner 25 %, bevorzugt kleiner 15 % sein.

Dabei soll der mit der Schicht absorbierte Anteil deutlich größer als der emittierte Anteil dieser Strahlungen sein.

Es kann sich dabei um Wärmestrahlung, die oberhalb der Wellenlängen des Wellenlängenspektrums der Sonnen liegt handeln. Dabei soll der mit der Schicht absorbierte Anteil deutlich größer als der emittierte Anteil dieser Strahlungen sein.

Die Schicht absorbiert den größten Teil der von der Sonne auf die Schicht emittierten Strahlung und es wird besonders vorteilhaft ein deutlich kleinerer Anteil an Strahlung aus dem Wellenlängenspektrum der von einem schwarzen Strahler emittierten Strahlung emittiert, so dass strahlungsbedingte Wärmeverluste reduziert werden können.

Dabei soll unter deutlich größerem Anteil ein Anteil von mindestens 75 %, bevorzugt mindestens 90 % verstanden werden. Dies sollte auf den gesamten Spektralbereich der von der Sonne emittierten Strahlung zu treffen. Demzufolge können ausgewählte Wellenlängenbereiche nahezu vollständig absorbiert werden.

Die Schicht ist mit Kohlenstoffnanoröhren gebildet und die Absorptions-, Emissions- und oder Transmissionseigenschaften, insbesondere der absorbierte Anteil der Strahlung, können durch den Masseanteil an Kohlenstoffnanoröhren pro Flächeneinheit oder Volumeneinheit auf der Oberfläche des Substrats beeinflusst werden.

Die die Schicht bildenden Kohlenstoffnanoröhren sollten unregelmäßig auf der Oberfläche des Substrats in der reflektierenden Schicht angeordnet sein. Sie sollen dabei überwiegend parallel in einer Ebene ausgerichtet sein, die parallel zur Oberfläche des Substrats oder einer auf der Oberfläche des Substrats ausgebildeten reflektierenden Schicht ausgerichtet ist.

Da die mit den Kohlenstoffnanoröhren gebildete Schicht insbesondere mechanisch nicht beständig ist und dadurch bei Kontakt entfernt werden kann, ist es vorteilhaft, die mit den Kohlenstoffnanoröhren gebildete Schicht mit einer Schutzschicht zu überdecken. Die Schutzschicht kann bevorzugt aus einem Oxid gebildet sein. Es kann ein Oxid eingesetzt werden, das ausgewählt ist aus SnO₂, TiO₂, SiO₂, ZnO, In₂O₃ und Al₂O₃. Die Schutzschicht sollte eine Schichtdicke im Bereich 20 nm bis 1000 nm aufweisen. Die Schutzschicht sollte eine hohe Transparenz oder eine hohe Reflektivität für von einem schwarzen Strahler emittierte Strahlung aufweisen. Sie kann beispielsweise aus SiO₂, TiO₂ oder Al₂O₃ gebildet sein, wodurch eine hohe Transparenz im Wellenlängenbereich des IR-Lichtes erreichbar ist. SnO₂, SnO₂:F oder andere elektrisch leitende und optisch transparente Oxide (TCO's) sind in diesem Wellenlängenbereich reflektiv.

Neben dem mechanischen Schutz kann mit einer Schutzschicht auch ein Schutz vor thermischen Einflüssen und dabei insbesondere einer Oxidation erreicht werden.

Das Substrat sollte auf der Oberfläche des Substrats mit einem Werkstoff beschichtet sein, der die Emission elektromagnetischer Strahlung reduziert oder aus einem solchen Werkstoff gebildet sein, so dass Wärmeverluste ausgehend vom Substrat in Richtung Umgebung durch abgestrahlte Strahlung reduziert werden können. Dieser Werkstoff kann ausgewählt sein aus Stahl, Aluminium, Kupfer, Silber, Gold, Nickel, Molybdän und Palladium. Damit kann erreicht werden, dass Energieverluste infolge von emittierter Strahlung zumindest deutlich reduziert werden können. So kann insbesondere eine Emission elektromagnetischer Strahlung aus dem Wellenlängenbereich der Strahlung, die von einem schwarzen Strahler emittiert wird, ausgehend vom erwärmten Substrat reduziert oder gar vermieden werden.

Bei der Erfindung besteht aber auch die Möglichkeit, einen Werkstoff für eine Schutzschicht einzusetzen, der elektromagnetische Strahlung aus dem Wellenlängenbereich des infraroten Lichts reflektiert und der für kleinere Wellenlängen optisch transparent ist. Er sollte dabei insbesondere die elektromagnetische Strahlung aus dem Wellenlängenspektrum eines schwarzen Strahlers zu mindestens 50 % reflektieren. Als Werkstoff können beispielsweise elektrisch leitende Oxide (TCO'S) eingesetzt werden.

In der Schicht sollten Kohlenstoffnanoröhren in einer ersten erfindungsgemäßen Alternative, die allein oder gemeinsam mit einer zweiten Alternative realisiert sein kann, mit einem Anteil von mindestens 0,05 g/m² und maximal 5 g/m², bevorzugt mindestens 0,25 g/m² und maximal 2,5 g/m² enthalten sein. Dabei verschiebt sich die vorgebbare Wellenlänge in Richtung höherer Wellenlängen mit einem erhöhten Anteil an enthaltenen Kohlenstoffnanoröhren.

Die Kohlenstoffnanoröhren enthaltende Schicht kann in einer zweiten erfindungsgemäßen Alternative eine Schichtdicke im Bereich 10 nm bis 2000 nm, bevorzugt 100 nm bis 1000 nm aufweisen.

Es können die verschiedensten unterschiedlichen Kohlenstoffnanoröhren, z.B. SWCNT's oder MWCNT's eingesetzt werden. Auch unterschiedlich dimensionierte Kohlenstoffnanoröhren können erfindungsgemäß eingesetzt werden. Neben der Anzahl der Wände haben auch die Struktur (Aufrollfaktor), die jeweiligen Durchmesser, Längen der Kohlenstoffnanoröhren, deren Reinheit (gereinigt, ungereinigt) sowie ggf. enthaltene Verunreinigungen (verschiedene Metall, Katalysatoren, Kohlenstoff in anderer Modifikation) einen Einfluss auf die optischen Eigenschaften.

Bei der Herstellung einer erfindungsgemäßen Beschichtung kann so vorgegangen werden, dass eine wässrige Dispersion, in der mindestens ein Tensid und Kohlenstoffnanoröhren gleichmäßig verteilt enthalten sind, auf die Oberfläche eines Substrats oder einer auf der Substratoberfläche ausgebildeten reflektierenden Schicht, die aus einem Werkstoff gebildet ist, der elektromagnetische Strahlung mit einer Wellenlänge größer als der vorgegebenen Wellenlänge mit mindestens 60 % reflektiert, aufgebracht wird. Im Anschluss daran werden das Wasser durch eine Trocknung und das Tensid mittels eines Lösungsmittels entfernt. Die Absorptions- und/oder Transmissionseigenschaften der so ausgebildeten Schicht können durch den Anteil an Kohlenstoffnanoröhren, der in der Dispersion eingehalten worden ist, beeinflusst werden.

Der Auftrag der Dispersion kann mit verschiedenen Vorgehensweisen erfolgen, so sind Sprühverfahren, Tauchverfahren, Druckverfahren geeignet.

Die vorab bereits beschriebene Schutzschicht kann bevorzugt mit einem CVD-Verfahren bei Atmosphärendruckbedingungen oder nasschemisch ausgebildet werden. Dabei werden Möglichkeiten für die Ausbildung einer solchen Schutzschicht in Ausführungsbeispielen nachfolgend noch beschrieben.

Die Erfindungsgemäße Beschichtung kann bei Absorbern für solartechnische Anwendungen verwendet werden. Dies betrifft insbesondere die Herstellung von Absorberrohren, die besonders bevorzugt in Parabol-Rinnen-Kollektoren eingesetzt werden können.

Die Erfindung zeichnet sich gegenüber dem Stand der Technik besonders durch die einfache und kostengünstige Herstellbarkeit aus, da auf Vakuumbeschichtungstechniken zumindest weitestgehend verzichtet werden kann. Zumindest die eigentliche absorbierende Schicht kann ohne ein solches aufwändiges Verfahren ausgebildet werden.

Durch den kleinen erforderlichen Anteil an Kohlenstoffnanoröhren sind auch die Materialkosten relativ niedrig.

Nachfolgend soll die Erfindung anhand von Ausführungsbeispielen näher erläutert werden.

Dabei zeigen:
Figur 1 ein Diagramm des Reflexionsverhaltens von Schichten mit unterschiedlichen Anteilen an Kohlenstoffnanoröhren pro Fläche bei verschiedenen Wellenlängen;
Figur 2 ein Diagramm des Reflexionsverhaltens von Schichten mit unterschiedlichen Anteilen an Kohlenstoffnanoröhren pro Fläche bei verschiedenen Wellenlängen und
Figur 3 das Reflexionsverhalten einer einwandige Kohlenstoffnanoröhren enthaltenen Schicht, die auf verschiedenen Substratmaterialien (Kupfer + Edelstahl) ausgebildet ist.

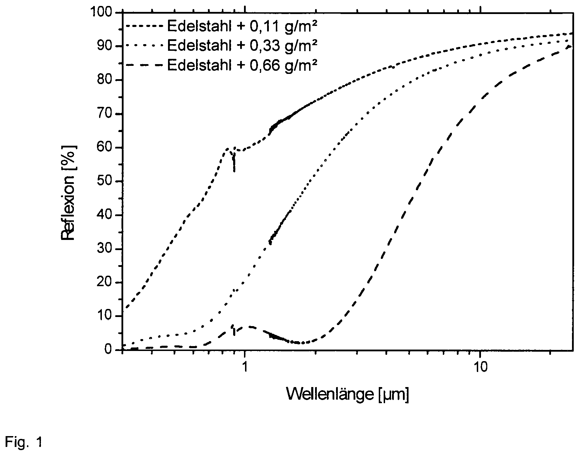

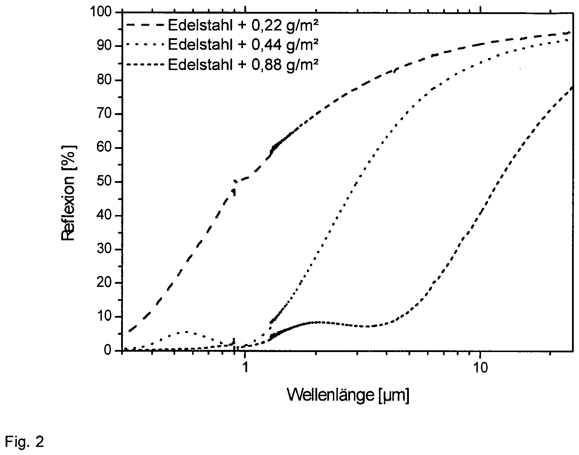

Die Figuren 1 und 2 zeigen Diagramme des Reflexionsverhaltens von Schichten mit unterschiedlichen Anteilen an Kohlenstoffnanoröhren pro Fläche bei den verschiedenen Wellenlängen. Dabei ist deutlich der erhöhte Einfluss der enthaltenen Kohlenstoffnanoröhrenanteile auf das Reflexionsverhalten und dabei die Verschiebung einer vorgegebenen Wellenlänge in Richtung höherer Wellenlängen mit steigendem Anteil an Kohlenstoffnanoröhren erkennbar.

Die mit mehrwandigen Kohlenstoffnanorören (MWCNT's) gebildeten Schichten wurden auf einem Edelstahlsubstrat (SS1.4301, IIId) abgeschieden.

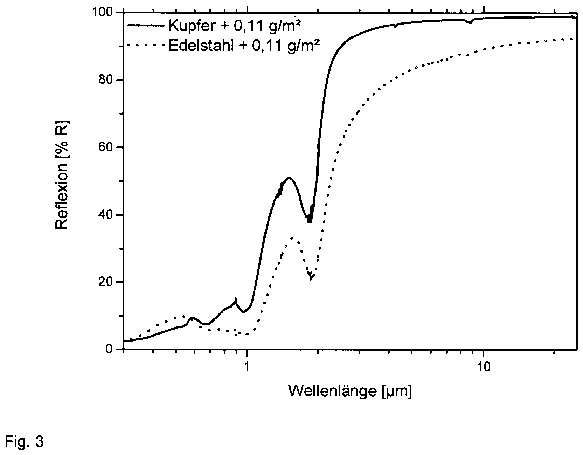

Figur 3 zeigt das Reflexionsverhalten einer einwandige Kohlenstoffnanoröhren (SWCNT's) enthaltenden Schicht, die auf verschiedenen Substratmaterialien (Kupfer + Edelstahl) abgeschieden ist. Das gute Absorptionsverhalten wird dabei maßgeblich durch die CNT-Schicht bestimmt. Die Selektivitätskante ist deutlich bei ca. 2 µm zu sehen. Bei höheren Wellenlängen ist die CNT-Schicht transparent, was durch die unterschiedlich reflektierenden Substrate gezeigt werden kann. Die Emission des Gesamtschichtsystems wird daher von der verwendeten Substratoberfläche bestimmt. Die solare Absorption wird maßgeblich durch die aufgebrachte CNT-Schicht erzeugt.

Bei den Beispielen soll allgemein voran gestellt werden, wie die Herstellung einer Dispersion und weitere nachfolgende Verfahrensschritte durchgeführt werden sollte. Diese Erklärung trifft dann auch auf nachfolgend noch zu beschreibende konkrete Beispiele zumindest sinngemäß zu.

Bei der Herstellung der Dispersion werden Kohlenstoffnanoröhren und ein geeignetes Tensid in einer Flüssigkeit, bevorzugt Wasser enthaltendes Gefäß gegeben. Da Kohlenstoffnanoröhren (CNT's) stark zu einer Agglomeration neigen, werden Agglomerate oder Cluster mittels einer Ultraschallbehandlung aufgebrochen. Mit dem Tensid können die CNT's in der Flüssigkeit (Wasser) stabilisiert und ein erneutes agglomerieren verhindert werden.

Zum Erhalt einer homogenen Dispersion können ggf. noch in der Dispersion enthaltene Agglomerate durch Zentrifugieren entfernt werden.

Eine so erhaltene Dispersion ist langzeitstabil und kann z.B. durch Sprühen aufgetragen werden. Nach dem Auftrag der Dispersion erfolgt das Trocknen, was durch eine Beheizung beschleunigt werden kann. Nach der Trocknung verbleibt auf der Oberfläche eine Schicht eines Netzwerks aus CNT's und dem jeweiligen Tensid. Da Tenside die optischen Eigenschaften beeinflussen sollte das Tensid entfernt werden. Hierfür kann ein für das jeweilige Tensid geeignetes Lösungsmittel (z.B. Ethanol) eingesetzt werden, mit dem es durch auswaschen entfernt werden kann. Nach dem Waschschritt verbleiben die CNT's allein auf der Oberfläche. Sie haften mechanisch nicht sehr stabil und können bei Berührung oder anderen Kontakten leicht entfernt werden. Außerdem sind sie gegen thermische oder auch andere äußere Einflüsse nicht sehr gut geschützt.

Aus diesen Gründen kann die mit den CNT's gebildete Schicht mit einer thermisch stabilen und optisch transparenten Schutzschicht fixiert und geschützt werden. Dadurch kann auch ein Oxidationsschutz erhalten werden. Die Schutzschicht sollte zumindest im Wellenlängenbereich, in dem elektromagnetische Strahlung (≤ der vorgebbaren Wellenlänge) erhöht absorbiert werden soll, optisch transparent sein und diese Strahlung auch nicht reflektieren. Sie kann als Antireflexionsschicht ausgebildet sein.

### Beispiel 1a:

Auf eine Substratoberfläche aus poliertem Edelstahl 1.4301 (IIId) wurde eine Dispersion mittels einer Airbrushdüse bei einem Arbeitsdruck von 4 bar aufgesprüht.

Die Dispersion wurde hergestellt, indem 0,1 Masse-% mehrwandiger CNT's, wie sie beispielsweise von der Firma Nanocyl kommerziell erhältlich sind und 0,1 Masse-% Natrium-Dodecylbenzen-Sulfonat als ein geeignetes Tensid in Wasser gegeben. Das Gemisch wurde über einen Zeitraum von 5 min Ultraschallwellen einer Frequenz von 20 kHz ausgesetzt, um Agglomerate aufzubrechen.

Anschließend wurde die Dispersion über 5 min bei 3260 g zentrifugiert. Es wurden 80 % der Dispersion oben entnommen und auf eine Oberfläche mit einer Größe 150 * 150 mm² aufgesprüht.

Dabei konnte auf der Oberfläche eine Schicht nach dem Trocknen und Auswaschen des Tensids erhalten werden, bei der ca. 0,5 g/m² CNT's vorhanden waren.

Im Anschluss daran wurde eine Schutzschicht aus SiO₂ auf die Schicht aufgebracht.

Hierfür wurden 10 ml Wasser, 50 ml Ethanol, 50 ml Tetraethylorthosilicat und 10 ml 100-%-ige Essigsäure vermischt und durch Dip-Coating die Mischung auf die Schicht aufgetragen. Dabei erfolgte das Tauchen einmalig mit einer Geschwindigkeit von 1 mm/s.

Dann wurde über 5 min getrocknet und im Anschluss daran wurde eine Wärmebehandlung bei 350 °C über einen Zeitraum von 5 min durchgeführt. Nach diesem Tempern war eine Schutzschicht aus SiO₂ mit einer Schichtdicke von 300 nm auf nasschemischem Wege erhalten worden. Es können aber auch andere Schichtdicken, beispielsweise 20 nm, 40 nm o. 60 nm erhalten werden.

Anstelle einer Schutzschicht aus SiO₂ kann eine Schutzschicht aus Al₂O₃, wie folgt beschrieben, ausgebildet werden.

Als Precursor werden 100 ml Al(iPrO)₃ (60 g/l) in n-Butanol mit ca. 1 Vol-% konzentrierter HNO₃ in Form einer Lösung zubereitet. Die Beschichtung erfolgt wieder durch Dip-Coating mit einmaligem Tauchen bei einer Tauchgeschwindigkeit von 1 mm/s.

Die Trocknung erfolgte über 5 min. Es wurde ebenfalls eine Wärmebehandlung bei 350 °C über 5 min durchgeführt.

Die Schutzschicht hatte eine Dicke von 40 nm.

### Beispiel 1b:

Auf eine Substratoberfläche aus Kupfer wurde eine Dispersion mittels einer Airbrushdüse bei einem Arbeitsdruck von 4 bar aufgesprüht.

Die Dispersion wurde hergestellt, indem 0,05 Masse-% SW-CNT's und 1 Masse-% Natrium-Dodecylbenzen-Sulfonat als ein geeignetes Tensid in Wasser gegeben. Das Gemisch wurde über einen Zeitraum von 15 min Ultraschallwellen einer Frequenz von 20 kHz ausgesetzt, um Agglomerate aufzubrechen.

Anschließend wurde die Dispersion über 5 min bei 3260 g zentrifugiert. Es wurden 80 % der Dispersion oben entnommen und auf eine Oberfläche mit einer Größe 150 * 150 mm² aufgesprüht.

Dabei konnten auf der Oberfläche Schichten nach dem Trocknen und Auswaschen des Tensids erhalten werden, bei denen ca. 0,1 g/m² bis 0,5 g/m²CNT's vorhanden waren.

Im Anschluss daran wurde eine Schutzschicht aus SiO₂ auf die Schicht aufgebracht.

Hierfür wurden 10 ml Wasser, 50 ml Ethanol, 50 ml Tetraethylorthosilicat und 10 ml 100-%-ige Essigsäure vermischt und durch Dip-Coating die Mischung auf die Schicht aufgetragen. Dabei erfolgte das Tauchen einmalig mit einer Geschwindigkeit von 1 mm/s.

Dann wurde über 5 min getrocknet und im Anschluss daran wurde eine Wärmebehandlung bei 350 °C über einen Zeitraum von 5 min durchgeführt. Nach diesem Tempern war eine Schutzschicht aus SiO₂ mit einer Schichtdicke von 300 nm auf nasschemischem Wege erhalten worden. Es können aber auch andere Schichtdicken, beispielsweise 20 nm, 40 nm o. 60 nm erhalten werden.

Anstelle einer Schutzschicht aus SiO₂ kann eine Schutzschicht aus Al₂O₃, wie folgt beschrieben, ausgebildet werden.

Als Precursor werden 100 ml Al(iPrO)₃ (60 g/l) in n-Butanol mit ca. 1 Vol-% konzentrierter HNO₃ in Form einer Lösung zubereitet. Die Beschichtung erfolgt wieder durch Dip-Coating mit einmaligem Tauchen bei einer Tauchgeschwindigkeit von 1 mm/s.

Die Trocknung erfolgte über 5 min. Es wurde ebenfalls eine Wärmebehandlung bei 350 °C über 5 min durchgeführt.

Die Schutzschicht hatte eine Dicke von 40 nm.

### Beispiel 2:

Bei diesem Beispiel wurde auf einer Schicht, die wie beim Beispiel 1 ausgebildet worden ist, eine Schutzschicht aus TiO₂ aufgebracht. Dabei wurden ein CVD-Verfahren unter Atmosphärendruckbedingungen sowie als Precursoren Titantetraisopropoxide und Wasser eingesetzt. Es wurde eine Temperatur von 200 °C eingehalten. Eine geeignete entsprechende Vorgehensweise ist in DE 10 2008 052 098 A1 beschrieben, so dass auf deren Offenbarungsgehalt hingewiesen und diesen auch zum Gegenstand dieser Beschreibung gemacht werden soll.

Die ausgebildete Schutzschicht hatte eine Schichtdicke von 65 nm.

### Beispiel 3

Auf die Oberfläche eines polierten Edelstahlsubstrats 1.4301 (IIId) wurde eine Dispersion aufgebracht, bei der in Wasser 0,1 Masse-% mehrwandige Kohlenstoffnanoröhren (MWCNT's) sowie 0,1 Masse-% Natrium-Dodecylbenzen-Sulfonat als Tensid enthalten waren. Die Dispersion wurde mittels Ultraschallwellen bei einer Frequenz von 20 kHz über 5 min deagglomeriert. Im Anschluss daran wurde die Dispersion über 5 min bei 3260 g zentrifugiert. Es wurden 80 % der Dispersion von oben entnommen, so dass keine Agglomerate beim Auftragen auf die Oberfläche, die mittels Aufsprühen mit einer Airbrushdüse bei einem Arbeitsdruck von 4 bar erfolgte, mit aufgesprüht wurden.

Nach dem Trocknen und Waschen, was wie beim Beispiel 1 durchgeführt werden kann, wurde eine Schutzschicht, die zusätzlich elektromagnetische Strahlung aus dem Wellenlängenbereich des infraroten Lichts mit mindestens 50 % reflektiert auf die mit den CNT's gebildet Schicht aufgebracht. Prinzipiell können unterschiedliche strahlungsselektive optisch transparente elektrisch leitende Oxide (z.B. ITO, AZO u.a.) hierfür eingesetzt werden. Bei diesem Beispiel wurde die Schutzschicht mit den IR-reflektierenden Eigenschaften aus mit Fluor dotiertem Zinnoxid gebildet.

Dabei wurde wieder ein CVD-Verfahren bei Atmosphärendruckbedingungen eingesetzt, wie dies beim Beispiel 2, der Fall war. Als Precursor wurden SnCl₄ und 5 Masse-% HF eingesetzt. Der Auftrag erfolgte bei einer Temperatur von 400 °C. Die Schichtdicke betrug 500 nm.

Die Precursoren wurden in einem Bubblergefäß erwärmt. Der sich einstellende Dampfdruck der jeweiligen Precursorflüssigkeit wird über einen Trägergasstrom zur Substratoberfläche gefördert. Die zu wählende Bubblertemperatur ist von der Dampfdruckkurve der Precursorflüssigkeit abhängig. Bei Zinntetrachlorid (SnCl₄) wurde die Bubblertemperatur auf 20 °C geregelt, bei den 5 Masse-% HF waren es 50 °C. Als Trägergas wurde Stickstoff eingesetzt. Der Trägergasvolumenstrom im SnCl₄ enthaltenden Bubblergefäß betrug 0,5 slm. Der Trägergasvolumenstrom im HF enthaltenden Bubblergefäß lag bei ca. 3 slm. Zur Vermeidung der Kondensation der gasförmigen Precursor wurden die Gasleitungen vom Bubblergefäß bis zu einem Beschichtungskopf auf 100 °C erwärmt. Zudem wurde der Trägergasstrom mit zusätzlichem Stickstoffträgergasstrom verdünnt.

Die Gasleitungen der beiden Precursoren wurden getrennt voneinander zum Beschichtungskopf geführt. Der Beschichtungskopf besteht prinzipiell aus zwei ineinander konzentrisch angeordneten Rohren.

Bei dem verwendeten CVD-Verfahren findet eine Hydrolysereaktion zwischen den verwendeten Precursoren (Zinntetrachlorid und Wasser bzw. Fluorwasserstoff statt). Eine Schichtbildung ist ab 200°C zu beobachten. Die Schichtabscheiderate ist stark Temperaturabhängig. Ein orientiertes kristallines Schichtwachstum findet ab Substrattemperaturen von ca. 300 - 350°C statt.

## Patentansprüche

1. Beschichtung, die mit einer Schicht, die auf der Oberfläche eines Substrats oder einer auf der Oberfläche des Substrats ausgebildeten reflektierenden Schicht ausgebildet ist, gebildet ist und die Schicht Anteile elektromagnetischer Strahlung aus dem Wellenlängenspektrum des Sonnenlichts absorbiert und der Anteil an elektromagnetischer Strahlung aus dem Wellenlängenspektrum eines schwarzen Strahlers bei einer Temperatur größer 50 °C, der emittiert wird, kleiner 25 % ist,
wobei
die Schicht mit in der Schicht enthaltenen Kohlenstoffnanoröhren gebildet ist und dabei der Anteil der pro Flächen- oder Volumeneinheit enthaltenen Kohlenstoffnanoröhren im Bereich 0,05 g/m² bis 5 g/m² und/oder die Schichtdicke der Schicht im Bereich 10 nm bis 2000 nm gehalten ist.

2. Beschichtung nach Anspruch 1, **dadurch gekennzeichnet, dass** die die Schicht bildenden Kohlenstoffnanoröhren unregelmäßig und dabei zumindest überwiegend in einer Ebene, die parallel zur Oberfläche des Substrats oder einer auf der Oberfläche ausgebildeten reflektierenden Schicht parallel zueinander ausgerichtet auf der Oberfläche des Substrats angeordnet sind.

3. Beschichtung nach einem der vorhergehenden Ansprüche, **dadurch gekennzeichnet, dass** die mit den Kohlenstoffnanoröhren gebildete Schicht mit einer Schutzschicht, die bevorzugt aus einem Oxid gebildet ist, überdeckt ist.

4. Beschichtung nach dem vorhergehenden Anspruch, **dadurch gekennzeichnet, dass** das Oxid ausgewählt ist aus SnO₂,TiO₂,SiO₂, ZnO, In₂O₃ und Al₂O₃.

5. Beschichtung nach einem der vorhergehenden Ansprüche, **dadurch gekennzeichnet, dass** das Substrat aus einem Werkstoff gebildet oder die Oberfläche des Substrats mit einem Werkstoff beschichtet ist, der elektromagnetische Strahlung aus dem Wellenlängenspektrum eines schwarzen Strahlers mit mindestens 60 % reflektiert, und die mit den Kohlenstoffnanoröhren gebildete Schicht auf der Substratoberfläche oder der so beschichteten Oberfläche des Substrats ausgebildet ist.

6. Beschichtung nach dem vorhergehenden Anspruch, **dadurch gekennzeichnet, dass** der Werkstoff ausgewählt ist aus Stahl, Aluminium, Kupfer, Silber, Gold, Nickel, Molybdän und Palladium.

7. Beschichtung nach einem der vorhergehenden Ansprüche, **dadurch gekennzeichnet, dass** in der Schicht Kohlenstoffnanoröhren mit einem Anteil mindestens 0,25 g/m² und maximal 2,5 g/m² enthalten sind.

8. Beschichtung nach einem der vorhergehenden Ansprüche, **dadurch gekennzeichnet, dass** die Schutzschicht eine Schichtdicke im Bereich 20 nm bis 1000 nm aufweist.

9. Beschichtung nach einem der vorhergehenden Ansprüche, **dadurch gekennzeichnet, dass** die Schutzschicht elektromagnetische Strahlung aus dem Wellenlängenbereich der von einem schwarzen Strahler emittierten Strahlung mit mindestens 50 % reflektiert.

10. Verfahren zur Herstellung einer Beschichtung nach einem der vorhergehenden Ansprüche, bei dem
eine Dispersion, in der mindestens ein Tensid und Kohlenstoffnanoröhren in einer Flüssigkeit, gleichmäßig verteilt enthalten sind,
auf die Oberfläche eines Substrats oder einer auf der Substratoberfläche ausgebildeten reflektierenden Schicht, die aus einem Werkstoff gebildet ist, der elektromagnetische Strahlung aus dem Wellenlängenspektrum, der von einem schwarzen Strahler emittierten elektromagnetischen Strahlung, mit mindestens 60 % reflektiert, aufgebracht wird,
und im Anschluss daran die Flüssigkeit durch eine Trocknung und das Tensid mittels eines Lösungsmittels entfernt werden, wobei die Absorptions- und/oder Transmissionseigenschaften der so ausgebildeten Schicht durch den Anteil an Kohlenstoffnanoröhren, der in der Dispersion eingehalten worden ist, beeinflusst werden, wobei ein Anteil an Kohlenstoffnanoröhrchen in der Schicht im Bereich 0,05 g/m² bis 5/m² und/oder eine Schichtdicke im Bereich 10 nm bis 2000 nm eingestellt wird.

11. Verfahren nach Anspruch 10, **dadurch gekennzeichnet, dass** auf der Schicht eine mit einem Oxid gebildete Schutzschicht ausgebildet wird, die bevorzugt aus TiO₂, SiO₂ oder Al₂O₃ oder einem teilweise optisch transparenten elektrisch leitenden Oxid gebildet ist, wobei die Schutzschicht bevorzugt mit einem CVD-Verfahren bei Atmosphärendruckbedingungen oder nasschemisch ausgebildet wird.

12. Verfahren nach Anspruch 10 oder 11, **dadurch gekennzeichnet, dass** als Flüssigkeit, in der ein Tensid und Kohlenstoffnanoröhrchen enthalten sind, Wasser eingesetzt wird.

13. Verwendung einer Beschichtung nach einem der Ansprüche 1 bis 9 für die Herstellung von Absorbern für solartechnische Anwendungen, insbesondere für die Herstellung von Absorberrohren.

## Claims

1. A coating comprising a layer which is formed on the surface of a substrate or on a reflective layer formed on the surface of the substrate and the layer absorbs proportions of electromagnetic radiation from the wavelength spectrum of sunlight and the proportion of electromagnetic radiation from the wavelength spectrum of a black radiator at a temperature greater than 50°C which is emitted is smaller than 25%,
wherein
the layer is formed by carbon nanotubes contained in the layer and in this respect the proportion of carbon nanotubes contained per unit of area or unit of volume is kept in the range from 0.05 g/m² to 5 g/m² and/or the layer thickness of the layer is kept in the range from 10 nm to 2000 nm.

2. A coating in accordance with claim 1, **characterized in that** the carbon nanotubes forming the layer are arranged on the surface of the substrate irregularly and in this respect at least predominantly in a plane which is aligned in parallel with one another in parallel with the surface of the substrate or of a reflective layer formed on the surface.

3. A coating in accordance with one of the preceding claims, **characterized in that** the layer formed by the carbon nanotubes is covered by a protective layer which is preferably formed from an oxide.

4. A coating in accordance with the preceding claim, **characterized in that** the oxide is selected from SnO₂, TiO₂, SiO₂, ZnO, In₂O₃ and Al₂O₃.

5. A coating in accordance with one of the preceding claims, **characterized in that** the substrate is formed from a material or the surface of the substrate is coated by a material which reflects electromagnetic radiation from the wavelength spectrum of a black radiator by at least 60%; and the layer formed by the carbon nanotubes is formed on the substrate surface or on the surface of the substrate coated in this manner.

6. A coating in accordance with the preceding claim, **characterized in that** the material is selected from steel, aluminum, copper, silver, gold, nickel, molybdenum and palladium.

7. A coating in accordance with one of the preceding claims, **characterized in that** carbon nanotubes are contained in the layer with a proportion of 0.25 g/m² and a maximum of 2.5 g/m².

8. A coating in accordance with one of the preceding claims, **characterized in that** the protective layer has a layer thickness in the range from 20 nm to 1000 nm.

9. A coating in accordance with one of the preceding claims, **characterized in that** the protective layer reflects electromagnetic radiation from the wavelength range of the radiation emitted by a black radiator by at least 50%.

10. A method of producing a coating in accordance with one of the preceding claims, in which
a dispersion in which at least one surfactant and carbon nanotubes are contained uniformly distributed in a liquid is applied to the surface of a substrate or of a reflective layer which is formed on the substrate surface and which is formed from a material which reflects electromagnetic radiation from the wavelength spectrum of the electromagnetic radiation emitted by a black radiator by at least 60%,
and subsequent thereto the liquid is removed by a drying and the surfactant is removed by means of a solvent, wherein the absorption properties and/or transmission properties of the layer formed in this manner are influenced by the proportion of carbon nanotubes which was observed in the dispersion, wherein a proportion of carbon nanotubes in the layer is set in the range from 0.05 g/m² to 5 g/m² and/or a layer thickness is set in the range from 10 nm to 2000 nm.

11. A method in accordance with claim 10, **characterized in that** a protective layer formed by an oxide is formed on the layer and is preferably formed from TiO₂, SiO₂ or Al₂O₃ or from a partly optically transparent, electrically conductive oxide, with the protective layer preferably being formed using a CVD process at atmospheric pressure conditions or in a wet chemical manner.

12. A method in accordance with claim 10 or 11, **characterized in that** water is used as liquid which contains a surfactant and carbon nanotubes.

13. Use of a coating in accordance with one of the claims 1 to 9 for the production of absorbers for technical solar applications, in particular for the production of absorber tubes.

## Revendications

1. Revêtement qui est formé d'une couche constituée sur la surface d'un substrat ou d'une couche réfléchissante constituée sur la surface du substrat, la couche absorbant des parts du rayonnement électromagnétique provenant du spectre de longueurs d'onde de la lumière solaire, et la part émise du rayonnement électromagnétique provenant du spectre de longueurs d'onde d'un corps noir étant, à une température supérieure à 50°C, inférieure à 25 %,
la couche étant formée de nanotubes de carbone contenus dans la couche, la part des nanotubes de carbone contenus dans l'unité d'aire ou dans l'unité de volume étant alors comprise dans la plage de 0,05 g/m² à 5 g/m², et/ou l'épaisseur de la couche étant maintenue dans la plage de 10 nm à 2000 nm.

2. Revêtement selon la revendication 1, **caractérisé en ce que** les nanotubes de carbone formant la couche sont disposés irrégulièrement sur la surface du substrat et alors au moins d'une manière prépondérante orientés parallèlement les uns aux autres dans un plan qui est orienté parallèlement à la surface du substrat ou à une couche réfléchissante constituée sur la surface.

3. Revêtement selon l'une des revendications précédentes, **caractérisé en ce que** la couche formée avec les nanotubes de carbone est recouverte d'une couche de protection qui de préférence est formée d'un oxyde.

4. Revêtement selon la revendication précédente, **caractérisé en ce que** l'oxyde est choisi parmi SnO₂, TiO₂, SiO₂, ZnO, In₂O₃ et Al₂O₃.

5. Revêtement selon l'une des revendications précédentes, **caractérisé en ce que** le substrat est formé d'un matériau, ou la surface du substrat est revêtue d'un matériau, qui réfléchit à raison d'au moins 60 % le rayonnement électromagnétique provenant du spectre de longueurs d'onde d'un corps noir, et la couche formée des nanotubes de carbone est constituée sur la surface du substrat ou sur la surface ainsi revêtue du substrat.

6. Revêtement selon la revendication précédente, **caractérisé en ce que** le matériau est choisi parmi l'acier, l'aluminium, le cuivre, l'argent, l'or, le nickel, le molybdène et le palladium.

7. Revêtement selon l'une des revendications précédentes, **caractérisé en ce que** la couche contient des nanotubes de carbone à raison d'au moins 0,25 g/m², et au maximum de 2,5 g/m².

8. Revêtement selon l'une des revendications précédentes, **caractérisé en ce que** la couche de protection présente une épaisseur de couche comprise dans la plage de 20 nm à 1000 nm.

9. Revêtement selon l'une des revendications précédentes, **caractérisé en ce que** la couche de protection réfléchit à raison d'au moins 50 % le rayonnement électromagnétique provenant de la plage de longueurs d'ondes du rayonnement émis par un corps noir.

10. Procédé de fabrication d'un revêtement selon l'une des revendications précédentes, dans lequel
on applique une dispersion, qui contient au moins un tensioactif et des nanotubes de carbone, uniformément répartis dans un liquide,
sur la surface d'un substrat ou d'une couche réfléchissante constituée sur la surface du substrat, qui est formée d'un matériau qui réfléchit à raison d'au moins 60 % le rayonnement électromagnétique provenant du spectre de longueurs d'onde, du rayonnement électromagnétique émis par un corps noir,
puis on élimine le liquide par un séchage et le tensioactif à l'aide d'un solvant, les propriétés d'absorption et/ou de transmission de la couche ainsi constituée étant influencées par la part des nanotubes de carbone qui a été maintenue dans la dispersion, ce à l'occasion de quoi on ajuste une part des nanotubes de carbone dans la couche à une valeur comprise dans la plage de 0,05 g/m² à 5 g/m², et/ou une épaisseur de couche dans la plage de 10 nm à 2000 nm.

11. Procédé selon la revendication 10, **caractérisé en ce qu'**on constitue sur la couche une couche de protection formée avec un oxyde, qui de préférence est formée de TiO₂, de SiO₂ ou d'Al₂O₃, ou d'un oxyde conducteur de l'électricité, partiellement optiquement transparent, la couche de protection étant constituée de préférence par un procédé CVD dans les conditions d'une pression atmosphérique, ou par un procédé chimique par voie humide.

12. Procédé selon la revendication 10 ou 11, **caractérisé en ce qu'**on utilise de l'eau en tant que liquide contenant un tensioactif et des nanotubes de carbone.

13. Utilisation d'un revêtement selon l'une des revendications 1 à 9 pour la fabrication d'absorbeurs pour les applications solaires, en particulier pour la fabrication de tubes absorbeurs.
